# EUROPEAN PATENT SPECIFICATION

(11) **EP 2 805 204 B1**
(45) Date of publication and mention of the grant of the patent: **11.09.2019**
(21) Application number: 13705402.9
(22) Date of filing: 16.01.2013
(51) Int. Cl.: G03F 7/20, G02B 26/08

(54) **MIRROR ARRANGEMENT, IN PARTICULAR FOR USE IN A MICROLITHOGRAPHIC PROJECTION EXPOSURE APPARATUS**
SPIEGELANORDNUNG, INSBESONDERE ZUR VERWENDUNG IN EINER MIKROLITHOGRAFISCHEN PROJEKTIONSBELICHTUNGSVORRICHTUNG
AGENCEMENT DE MIROIRS, EN PARTICULIER POUR ÊTRE UTILISÉ DANS UN APPAREIL D'EXPOSITION PAR PROJECTION MICROLITHOGRAPHIQUE

(30) Priority: 19.01.2012 DE 102012200736; 19.01.2012 US 201261588226 P
(43) Date of publication of application: 26.11.2014
(73) Proprietor: Carl Zeiss SMT GmbH, 73447 Oberkochen (DE)
(72) Inventor: PNINI-MITTLER, Boaz, 73572 Heuchlingen (DE)
(74) Representative: Frank, Hartmut
(86) International application number: PCT/EP2013/050721
(87) International publication number: WO 2013/107762

(56) References cited:
- WO-A2-2010/049076
- US-A1- 2007 139 752
- US-A1- 2007 236 675

## Description

### CROSS REFERENCE TO RELATED APPLICATIONS

This application claims priority of German Patent Application DE 10 2012 200 736.9 and US 61/588,226, both filed on January 19, 2012.

### BACKGROUND OF THE INVENTION

### Field of the invention

The invention relates to a mirror arrangement, in particular for use in a microlithographic projection exposure apparatus. In particular, the invention relates to a facet mirror of an illumination device of a microlithographic projection exposure apparatus.

### State of the art

Microlithography is used for producing microstructured components such as, for example, integrated circuits or LCDs. The microlithography process is carried out in a so-called projection exposure apparatus comprising an illumination device and a projection lens. The image of a mask (= reticle) illuminated by means of the illumination device is in this case projected by means of the projection lens onto a substrate (e.g. a silicon wafer) coated with a light-sensitive layer (photoresist) and arranged in the image plane of the projection lens, in order to transfer the mask structure to the light-sensitive coating of the substrate.

In projection lenses designed for the EUV range, that is to say at wavelengths of e.g. approximately 13 nm or approximately 7 nm, owing to lack of availability of suitable light-transmissive refractive materials, mirrors are used as optical components for the imaging process.

In the illumination device of a microlithographic projection exposure apparatus designed for operation in the EUV, the use of facet mirrors in the form of field facet mirrors and pupil facet mirrors as beam-guiding components is known e.g. from DE 10 2008 009 600 A1. Such facet mirrors are constructed from a multiplicity of individual mirrors which are designed to be tiltable by means of flexures in each case for the purpose of adjustment or else for realizing specific illumination angle distributions.

In this case, it is conventionally customary, in particular, to integrate the corresponding flexures directly into the individual mirrors. However, such a configuration of the individual mirrors with integrated flexures has the disadvantage that as a result of flexures additionally integrated in the individual mirrors, which as optical precision components are complicated to manufacture anyway, the complexity of the relevant optical components and thus also the manufacturing outlay and costs of the apparatus overall are significantly increased. This holds true all the more when the individual mirrors are not produced from a metallic material such as copper, for example, but rather - for instance in order to comply with specific EUV specifications - from a ceramic material (e.g. silicon), in which, owing to the typically brittle material properties, the realization of flexures is particularly difficult and costly to realize.

US 2007/236675 A1 discloses an arrangement for an individually controllable element for use in a patterning array. The individually controllable element includes a reflector and hinges mounted to supports that can be fixed relative to the remainder of the array of individually controllable elements. The reflector and the hinges can be integrally formed. The hinges of adjacent individually controllable elements can be connected to each other and/or connected to a common support.

### SUMMARY OF THE INVENTION

Against the above background, it is an object of the present invention to provide a mirror arrangement comprising a plurality of individual mirrors, in particular for use in a microlithographic projection exposure apparatus, in which the required actuatability or tiltability of the individual mirrors is realized with comparatively little outlay in terms of manufacturing technology.

This object is achieved by means of the features of independent Claim 1.

The invention is based on the concept, in particular, in the case of a mirror arrangement comprising a plurality of individual mirrors each tiltable by means of flexures (solid joints, hinges), of integrating the flexures into a common component (common to all the individual mirrors or to all the flexures) which, however, is embodied mechanically separately from the individual mirrors. The invention thus creates, in particular, a modular construction in so far as the individual mirrors of the mirror arrangement are manufactured as purely optical components without additional mechanical functionality, whereas the functionality required for the actuation of the individual mirrors is provided by a component which is separate from the individual mirrors and which contains all the flexures in an integrated fashion. Consequently, the complexity and manufacturing outlay of the mirror arrangement according to the invention are significantly reduced as a result.

On account of the modular construction explained above, in particular the individual mirrors, on the one hand, and the component having the flexures, on the other hand, can be produced from different materials which are optimal with regard to the intended use. Thus, for instance, the flexures can still be formed from a suitable metallic material, whereas the individual mirrors, for instance in order to comply with specific EUV specifications, can be produced from ceramic material, such as e.g. silicon.

In the mirror arrangement according to the invention, the common component having the flexures is releasably connected to the individual mirrors, wherein this releasable connection can be realized, in particular, as explained in even greater detail below, by means of a clamping connection.

In accordance with one embodiment, the flexures are embodied as leaf spring flexures. These leaf spring flexures can be embodied, in particular, in a flexure plate (or hinge plate) forming the common component. For this purpose, by way of example, the flexure plate forming the common component can be manufactured as a metal sheet into which the leaf spring flexures are directly cut (e.g. by means of photo-etching).

In accordance with one embodiment, each of the flexures enables an actuation of the respectively assigned individual mirror, which is mechanically coupled in particular by means of a mechanical clamping connection, in two rotational degrees of freedom. Specifically, the individual mirrors can be tiltable about two mutually perpendicular tilting axes e.g. in a plane (x-y plane) perpendicular to the direction of light incidence.

Furthermore, the flexures are preferably embodied such that they enable an actuation of the respectively assigned individual mirror in (exactly) one translational degree of freedom. In this case, in particular, the individual mirrors can each be displaceable or movable by means of the assigned flexure in an axial direction, or direction perpendicular to the mirror plane by means of the flexure, as a result of which, in particular, thermal expansions occurring during operation, for example linear expansions of a pin or plunger respectively mounted on the individual mirrors for the actuation thereof are absorbed.

In accordance with one embodiment, the common component having the flexures is areally fixedly connected to a carrier e.g. by means of a soldering or welding connection (for instance by means of diffusion or laser welding using a multiplicity of welding spots). Said carrier can be, in particular (but without the invention being restricted thereto), a component of a cooler for cooling the mirror arrangement (for instance an upper cooler plate of said cooler).

The invention furthermore relates to an optical system, in particular an illumination device, of a microlithographic projection exposure apparatus, wherein the optical system comprises a mirror arrangement according to the invention comprising the features described above. Furthermore, the invention also relates to a microlithographic projection exposure apparatus, in particular for EUV lithography, comprising such an optical system.

Further configurations of the invention can be gathered from the description and from the dependent claims.

The invention is explained in greater detail below on the basis of exemplary embodiments illustrated in the accompanying drawings.

### BRIEF DESCRIPTION OF THE DRAWINGS

In the drawings:
- Figures 1-3: show schematic illustrations for elucidating an embodiment of the invention; and
- Figure 4: shows a schematic illustration of the construction of a microlithographic projection exposure apparatus in which the invention can be realized.

### DETAILED DESCRIPTION OF PREFERRED EMBODIMENTS

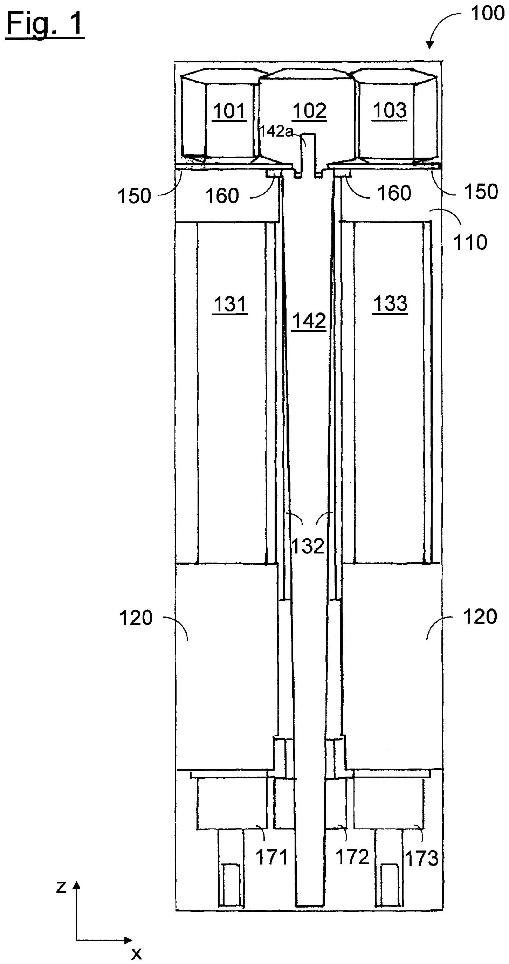

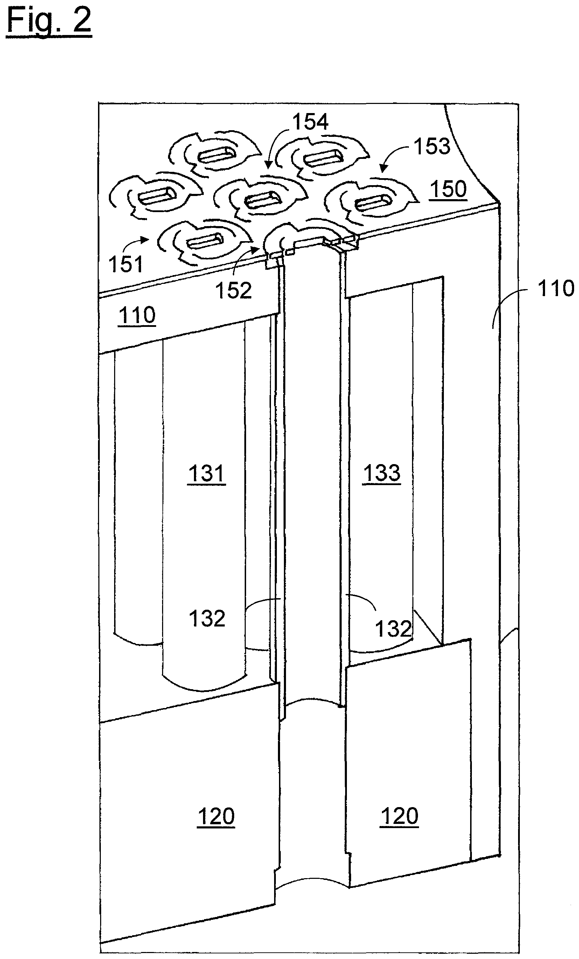

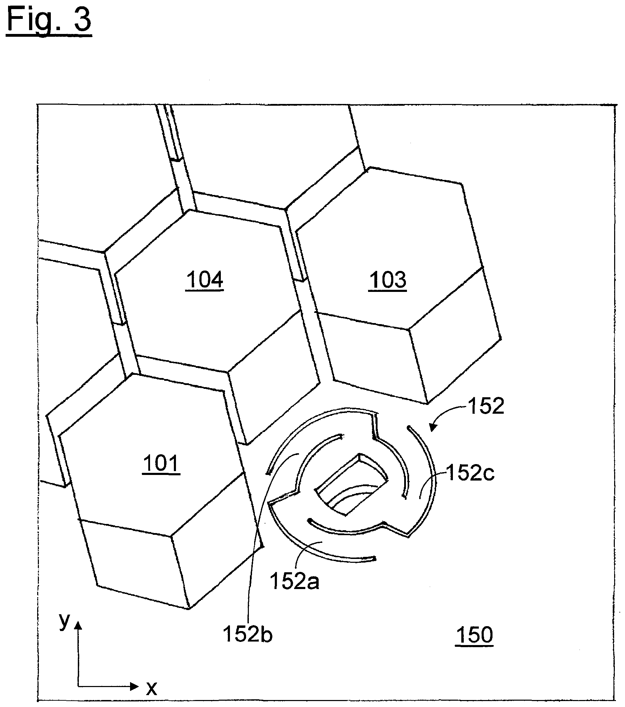

The construction of a mirror arrangement according to the invention is described below on the basis of an embodiment with reference to the schematic illustrations in Fig. 1-3. In this case, Fig. 1 shows a schematic cross-sectional view, Fig. 2 shows a perspective view of an excerpt from the arrangement (omitting the individual mirrors) and Fig. 3 shows an enlarged perspective illustration of part of the mirror arrangement and in particular of a flexure contained therein.

As can best be seen from Fig. 1 and 3, a mirror arrangement according to the invention comprises a plurality of individual mirrors 101, 102, 103, 104,... which are in each case tiltable about at least one tilting axis (about two mutually perpendicular tilting axes in the exemplary embodiment) by means of a flexure 151, 152, 153, 154,.... As can best be seen from Fig. 2, the flexures 151, 152, 153, 154,... are integrated into a common component, which in the exemplary embodiment is embodied as a flexure plate 150, in which the flexures 151, 152, 153, 154,... are integrated as leaf spring flexures by the production of corresponding cutouts in the flexure plate 150 (for instance by means of photo-etching).

In the specific exemplary embodiment, the flexures 151, 152, 153, 154,... are equipped in such a way that, in addition to the actuatability in two rotational degrees of freedom (corresponding to a rotation about the x- and y-axis, respectively, i.e. the degrees of freedom Rx and Ry), an actuatability in one translational degree of freedom (corresponding to a displaceability along the z-axis) is provided. As illustrated for the flexure 152 in Fig. 3, for this purpose each flexure 151, 152, 153, 154,... is embodied with three sections 152a, 152b and 152c, which are cut out in a wing-like manner and run in a tangential direction relative to the z-axis, and is produced as a leaf spring flexure.

While the tiltability of the individual mirrors that is required e.g. for adjustment purposes is ensured by the degrees of freedom Rx and Ry, a thermal expansion (e.g. a linear expansion), occurring during operation, of a pin or plunger 142, which is shown in Fig. 1 and serves, inter alia, for actuating the relevant individual mirror 102, can be absorbed by the additional translational degree of freedom in the z-direction.

Referring once again to Fig. 1, the relevant pins or plungers assigned to the individual mirrors 101, 102, 103, 104,... (only the pin or plunger 142 of which can be seen) are in each case arranged within a tubular or sleeve-shaped element 131, 132, 133,... and screwed into the mirror body (provided with a thread in each case) of the respectively assigned individual mirror 101, 102, 103,... (by means of a threaded pin 142a provided at the end side in accordance with Fig. 1).

As can best be seen from Fig. 1, the flexure plate 150 forming the common component for the integration of the flexures 151, 152, 153, 154,... is releasably connected to the individual mirrors 101, 102, 103, 104,... by means of a clamping connection. Specifically, this clamping of the flexure plate 150 is effected in the exemplary embodiment between the individual mirrors 101, 102, 103, 104,..., on the one hand, and a carrier 110, on the other hand, wherein said carrier in turn in the exemplary embodiment forms a component of a cooler (formed from the carrier 110 and also a further cooling plate 120) for cooling the mirror arrangement. The cooling fluid used for cooling flows within said cooler in the region between the tubular or sleeve-shaped elements 131, 132, 133,..., wherein said tubular elements 131, 132, 133,..., as already described, respectively receive in their interior one of the pins (e.g. the pin 142 in Fig. 1) screwed into the respective individual mirror 101, 102, 103, 104,..., and wherein said pins, for their part, are fixed by means of fixing elements 171, 172, 173, ..., e.g. in the form of screws, said fixing elements being situated on the underside or on the side of the lower cooler plate 120 facing away from the individual mirrors 101, 102, 103, 104,....

In the exemplary embodiment, the connection between the flexure plate 150 and the carrier 110 is realized as an areal connection in particular by soldering or welding (e.g. diffusion or laser welding with a multiplicity of welding spots). As can be seen from Fig. 1, furthermore, the flexure plate 150, in the region below the edge section of each individual mirror, is in each case provided with a recess 160 in the form of a drilled-out hole, which has the effect that in this region the flexure plate 150 has a play required for adjustment. This takes account of the circumstance that the point of rotation of the respective flexure 151, 152, 153, 154,... lies on the element axis of the respective individual mirror 101, 102, 103, 104,..., such that the flexure 151, 152, 153, 154,... moves upward somewhat on one of its sides and downward somewhat on its other side during the adjustment, which is permitted by the recess 160.

Without the invention being restricted to this, exemplary dimensions of the arrangements shown in Fig. 1-3 can be realized for instance as follows: In the case of an exemplary distance between the respective axes of the individual mirrors 101, 102, 103, 104,... of the order of magnitude of a few millimeters (e.g. 5 mm), the flexures 151, 152, 153, 154,... can be realized for instance with an external diameter of the respective leaf spring flexures of approximately 4 mm given a thickness of the flexure plate of a few tenths of a millimeter (e.g. 0.3 mm). As material of the flexure plate 150 it is possible (likewise without the invention being restricted to this) to use e.g. a metal having good thermal conductivity such as a copper alloy, for instance.

Even though the invention has been described above on the basis of a facet mirror (in particular a pupil facet mirror) as exemplary embodiment, the invention is not restricted thereto. Thus, a further exemplary possibility for realization also consists in a micro mirror arrangement designated as "MMA" (= "Micro Mirror Array"), such as is used in an illumination device for producing different illumination settings (i.e. intensity distributions in a pupil plane of the illumination device) and which likewise has a multiplicity of individual mirrors that are adjustable independently of one another. Such an illumination device or the associated microlithographic projection exposure apparatus can also be designed for DUV operation (that is to say at wavelengths of e.g. approximately 193 nm or approximately 157 nm).

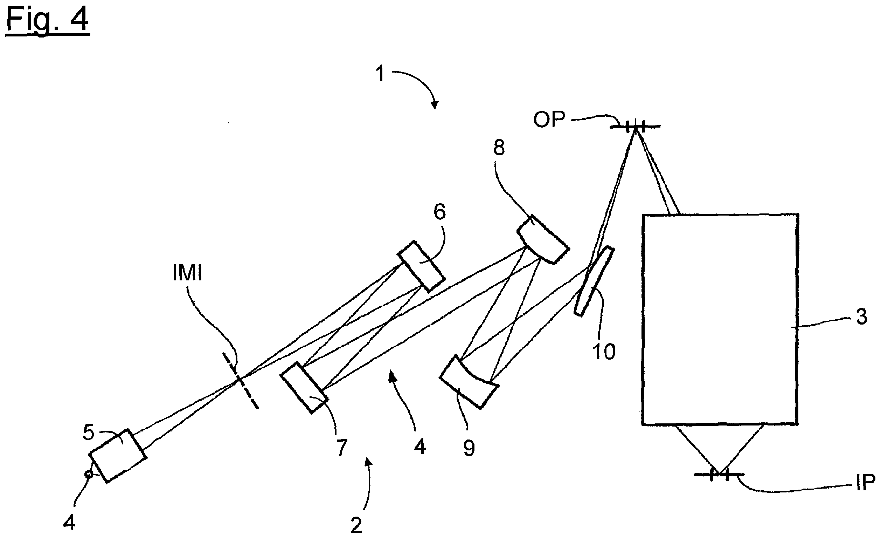

Fig. 4 shows only schematically the construction of a microlithographic projection exposure apparatus which is designed for operation in the EUV and in which the present invention can be realized.

The microlithographic projection exposure apparatus 1 illustrated in Fig. 4 comprises an illumination device 2 and a projection lens 3, wherein the illumination device illuminates an object plane OP of the projection lens 3. The EUV illumination light generated by a plasma radiation source 4 passes via a collector mirror 5 onto an intermediate focal plane IMI and from there via a field facet mirror 6 onto a pupil facet mirror 7, which can be configured in accordance with the embodiments described above. From the pupil facet mirror 7, the illumination light passes via a transfer optical unit composed of mirrors 8-10 into the object plane OP, in which a mask (reticle) having structures to be imaged is arranged. The mask structures are transferred via the projection lens 3 to the light-sensitive coating of a substrate (wafer) situated in the image plane IP of the projection lens 3.

Even though the invention has been described on the basis of specific embodiments, numerous variations and alternative embodiments are apparent to the person skilled in the art, e.g. by combination and/or exchange of features of individual embodiments. Accordingly, it goes without saying to the person skilled in the art that such variations and alternative embodiments are concomitantly encompassed by the present invention, and the scope of the invention is restricted only within the meaning of the accompanying patent claims.

## Claims

1. Mirror arrangement, in particular for use in a microlithographic projection exposure apparatus, comprising:
• a plurality of individual mirrors (101, 102, 103, 104,...); and
• a plurality of flexures (151, 152, 153, 154,...), wherein each individual mirror (101, 102, 103, 104,...) is tiltable about at least one tilting axis by means of one of said flexures;
• wherein the flexures (151, 152, 153, 154,...) are integrated into a common component, which is embodied mechanically separately from the individual mirrors;
and
• wherein the individual mirrors (101, 102, 103, 104,...) are releasably connected to the common component.

2. Mirror arrangement according to Claim 1, **characterized in that** it is a facet mirror, in particular a pupil facet mirror of an illumination device of a microlithographic projection exposure apparatus.

3. Mirror arrangement according to Claim 1 or 2, **characterized in that** this releasable connection is effected by means of a clamping connection.

4. Mirror arrangement according to any of the claims 1 to 3, **characterized in that** the flexures (151, 152, 153, 154,...) are embodied as leaf spring flexures.

5. Mirror arrangement according to Claim 4, **characterized in that** the leaf spring flexures are embodied in a flexure plate (150) forming the common component.

6. Mirror arrangement according to any of the preceding claims, **characterized in that** the common component is areally fixedly connected to a carrier (110).

7. Mirror arrangement according to Claim 6, **characterized in that** this areal connection is effected by means of a soldering or welding connection.

8. Mirror arrangement according to Claim 6 or 7, **characterized in that** the carrier (110) is a component of a cooler for cooling the mirror arrangement.

9. Mirror arrangement according to any of the preceding claims, **characterized in that** each of said flexures (151, 152, 153, 154,...) enables an actuation of the respectively assigned individual mirror (101, 102, 103, 104,...) in two rotational degrees of freedom (Rx, Ry).

10. Mirror arrangement according to any of the preceding claims, **characterized in that** each of said flexures (151, 152, 153, 154,...) enables an actuation of the respectively assigned individual mirror (101, 102, 103, 104,...) in one translational degree of freedom (z).

11. Mirror arrangement according to any of the preceding claims, **characterized in that** the individual mirrors (101, 102, 103, 104,...) and the common component are produced from mutually different materials.

12. Mirror arrangement according to any of the preceding claims, **characterized in that** the individual mirrors (101, 102, 103, 104,...) are produced from a ceramic material.

13. Mirror arrangement according to any of the preceding claims, **characterized in that** it is a facet mirror, in particular a pupil facet mirror of an illumination device.

14. Optical system of a microlithographic projection exposure apparatus, **characterized in that** the optical system comprises a mirror arrangement according to any of the preceding claims.

15. Microlithographic projection exposure apparatus, in particular for EUV-lithography, **characterized in that** it comprises an optical system according to Claim 14.

## Patentansprüche

1. Spiegelanordnung, insbesondere zur Verwendung in einer mikrolithografischen Projektionsbelichtungsvorrichtung, umfassend:
• eine Vielzahl von einzelnen Spiegeln (101, 102, 103, 104,...); und
• eine Vielzahl von Biegeelementen (151, 152, 153, 154,...), wobei jeder einzelne Spiegel (101, 102, 103, 104,...) um mindestens eine Schwenkachse mittels eines der Biegeelemente schwenkbar ist;
• wobei die Biegeelemente (151, 152, 153, 154, ... ) in eine gemeinsame Komponente integriert sind, die von den einzelnen Spiegeln mechanisch getrennt ausgeführt ist;
und
• wobei die einzelnen Spiegel (101, 102, 103, 104,...) lösbar mit der gemeinsamen Komponente verbunden sind.

2. Spiegelanordnung nach Anspruch 1, **dadurch gekennzeichnet, dass** sie ein Facettenspiegel, insbesondere ein Pupillenfacettenspiegel einer Beleuchtungsvorrichtung einer mikrolithografischen Projektionsbelichtungsvorrichtung ist.

3. Spiegelanordnung nach Anspruch 1 oder 2, **dadurch gekennzeichnet, dass** diese lösbare Verbindung mittels einer Klemmverbindung realisiert ist.

4. Spiegelanordnung nach einem der Ansprüche 1 bis 3, **dadurch gekennzeichnet, dass** die Biegeelemente (151, 152, 153, 154,...) als Blattfederbiegeelemente ausgebildet sind.

5. Spiegelanordnung nach Anspruch 4, **dadurch gekennzeichnet, dass** die Blattfederbiegungen in einer die gemeinsame Komponente bildenden Biegeplatte (150) ausgeführt sind.

6. Spiegelanordnung nach einem der vorhergehenden Ansprüche, **dadurch gekennzeichnet, dass** die gemeinsame Komponente flächenhaft fest mit einem Träger (110) verbunden ist.

7. Spiegelanordnung nach Anspruch 6, **dadurch gekennzeichnet, dass** diese flächenhafte Verbindung mittels einer Löt- oder Schweißverbindung realisiert ist.

8. Spiegelanordnung nach Anspruch 6 oder 7, **dadurch gekennzeichnet, dass** der Träger (110) eine Komponente eines Kühlers zum Kühlen der Spiegelanordnung ist.

9. Spiegelanordnung nach einem der vorhergehenden Ansprüche, **dadurch gekennzeichnet, dass** jede der Biegungen (151, 152, 153, 154,...) eine Betätigung des jeweils zugeordneten einzelnen Spiegels (101, 102, 103, 104,...) in zwei Rotationsfreiheitsgraden (Rx, Ry) ermöglicht.

10. Spiegelanordnung nach einem der vorhergehenden Ansprüche, **dadurch gekennzeichnet, dass** jede der Biegungen (151, 152, 153, 154,...) eine Betätigung des jeweils zugeordneten einzelnen Spiegels (101, 102, 103, 104,...) in einem translatorischen Freiheitsgrad (z) ermöglicht.

11. Spiegelanordnung nach einem der vorhergehenden Ansprüche, **dadurch gekennzeichnet, dass** die einzelnen Spiegel (101, 102, 103, 104,...) und die gemeinsame Komponente aus gegenseitig unterschiedlichen Materialien hergestellt sind.

12. Spiegelanordnung nach einem der vorhergehenden Ansprüche, **dadurch gekennzeichnet, dass** die einzelnen Spiegel (101, 102, 103, 104,...) aus einem keramischen Material hergestellt sind.

13. Spiegelanordnung nach einem der vorhergehenden Ansprüche, **dadurch gekennzeichnet, dass** sie ein Facettenspiegel, insbesondere ein Pupillenfacettenspiegel einer Beleuchtungsvorrichtung ist.

14. Optisches System einer mikrolithografischen Projektionsbelichtungsvorrichtung, **dadurch gekennzeichnet, dass** das optische System eine Spiegelanordnung nach einem der vorhergehenden Ansprüche umfasst.

15. Mikrolithografische Projektionsbelichtungsvorrichtung, insbesondere für die EUV-Lithographie, **dadurch gekennzeichnet, dass** sie ein optisches System nach Anspruch 14 umfasst.

## Revendications

1. Agencement de miroirs, en particulier à utiliser dans un appareil d'exposition par projection microlithographique, comprenant:
une pluralité de miroirs individuels (101, 102, 103, 104, ...) ; et
une pluralité de pivots (151, 152, 153, 154, ...), dans lequel chaque miroir individuel (101, 102, 103, 104, ...) est inclinable autour d'au moins un axe d'inclinaison au moyen de l'un desdits pivots;
dans lequel les pivots (151, 152, 153, 154, ...) sont intégrés dans un composant commun, qui est incorporé d'une façon mécaniquement séparée des miroirs individuels;
et dans lequel les miroirs individuels (101, 102, 103, 104, ...) sont connectés de façon détachable au composant commun.

2. Agencement de miroirs selon la revendication 1, **caractérisé en ce qu'**il s'agit d'un miroir à facettes, en particulier d'un miroir à facettes pupillaires d'un dispositif d'éclairage d'un appareil d'exposition par projection microlithographique.

3. Agencement de miroirs selon la revendication 1 ou 2, **caractérisé en ce que** cette connexion détachable est réalisée au moyen d'une connexion à serrage.

4. Agencement de miroirs selon l'une quelconque des revendications 1 à 3, **caractérisé en ce que** les pivots (151, 152, 153, 154, ...) sont incorporés comme des pivots à ressort à lame.

5. Agencement de miroirs selon la revendication 4, **caractérisé en ce que** les pivots à ressort à lame sont incorporés dans une plaque de pivots (150) qui constitue le composant commun.

6. Agencement de miroirs selon l'une quelconque des revendications précédentes, **caractérisé en ce que** le composant commun est connecté fixement de façon surfacique à un support (110).

7. Agencement de miroirs selon la revendication 6, **caractérisé en ce que** cette connexion surfacique est réalisée au moyen d'une connexion par brasage ou par soudage.

8. Agencement de miroirs selon la revendication 6 ou 7, **caractérisé en ce que** le support (110) est un composant d'un refroidisseur pour refroidir l'agencement de miroirs.

9. Agencement de miroirs selon l'une quelconque des revendications précédentes, **caractérisé en ce que** chacun desdits pivots (151, 152, 153, 154, ...) permet un actionnement du miroir individuel respectivement associé (101, 102, 103, 104, ...) dans deux degrés de liberté de rotation (Rx, Ry).

10. Agencement de miroirs selon l'une quelconque des revendications précédentes, **caractérisé en ce que** chacun desdits pivots (151, 152, 153, 154, ...) permet un actionnement du miroir individuel respectivement associé (101, 102, 103, 104, ...) dans un degré de liberté de rotation (z).

11. Agencement de miroirs selon l'une quelconque des revendications précédentes, **caractérisé en ce que** les miroirs individuels (101, 102, 103, 104, ...) et le composant commun sont produits à partir de matériaux mutuellement différents.

12. Agencement de miroirs selon l'une quelconque des revendications précédentes, **caractérisé en ce que** les miroirs individuels (101, 102, 103, 104, ...) sont produits à partir d'un matériau de céramique.

13. Agencement de miroirs selon l'une quelconque des revendications précédentes, **caractérisé en ce qu'**il s'agit d'un miroir à facettes, en particulier d'un miroir à facettes pupillaires d'un dispositif d'éclairage.

14. Système optique d'un appareil d'exposition par projection microlithographique, **caractérisé en ce que** le système optique comprend un agencement de miroirs selon l'une quelconque des revendications précédentes.

15. Appareil d'exposition par projection microlithographique, en particulier pour une lithographie à ultraviolet extrême (EUV), **caractérisé en ce qu'**il comprend un système optique selon la revendication 14.
